# EUROPEAN PATENT SPECIFICATION

(11) **EP 0 547 892 B1**
(45) Date of publication and mention of the grant of the patent: **28.10.1998**
(21) Application number: 92311514.1
(22) Date of filing: 16.12.1992
(51) Int. Cl.: G11C 7/00, G11C 11/409

(54) **An integrated circuit with self-biased differential data lines**
Integrierte Schaltung mit gegenseitig gesteuerten differenzialen Datenleitungen
Circuit intégré avec des lignes de données différentielles auto polarisées

(30) Priority: 17.12.1991 US 809733; 17.12.1991 US 809735
(43) Date of publication of application: 23.06.1993
(73) Proprietor: SGS-THOMSON MICROELECTRONICS, INC., Carrollton Texas 75006 (US)
(72) Inventor: McClure, David Charles, Carrollton, Texas 75007 (US)
(74) Representative: Palmer, Roger

(56) References cited:
- EP-A- 0 408 032
- US-A- 5 062 082
- IEEE JOURNAL OF SOLID-STATE CIRCUITS, vol.SC-21, no.5, October 1986, NEW YORK US pages 686 - 691 KAYANO ET AL '25-ns 256Kx1/64Kx4 CMOS SRAMs'
- TRANSACTIONS OF THE INSTITUTE OF ELECTRONICS, INFORMATION AND COMMUNICATION ENGINEERS OF JAPAN, vol.E74, no.4, April 1991, TOKYO JP pages 799 - 810, XP000241300 NAKAGOME ET AL 'Reviews and Prospects of DRAM Technology'

## Description

This invention is in the field of integrated circuits, and is more particularly directed to data communication therewithin.

This application is related to European Patent Publication No 0547891 and 0547889.

Many integrated circuits communicate multiple bits of digital data in parallel at various times in their operation by way of an internal data bus, consisting of a set of parallel conductors to which multiple circuit functions are connected. In particular, memory circuits often include a data bus to facilitate access from memory cells at various locations within the chip. For example, an internal data bus is particularly useful in memories organized into sub-arrays, or blocks of memory cells, where access of a selected memory cell does not require enabling of the entire memory device. The resulting power savings makes such partitioned memory arrays especially useful in low power memories for portable computers.

Modern memory circuits are required to operate at high speeds while being fabricated with the highest density technology. In such memories, the series resistance and parasitic capacitance of relatively long conductors, such as data bus lines, can become a significant factor in the operating performance of the memory, as such parasitic capacitance affects the time required for the conductor to switch from one digital state to the other. Furthermore, as memory circuits become increasingly dense, the cross-sectional area allowable for the data bus conductors decreases, in turn increasing the resistance of the data bus conductors and increasing the time constant of its switching, particularly if the data bus conductor must fully switch between ground and the power supply voltage (i.e., from "rail to rail").

Of course, the increased R-C load of the data bus conductors can be overcome by increasing the size of the transistors driving the bus. Increases in the size of transistors of course runs counter to the desire to increase the density of memory integrated circuits. Furthermore, the driver transistors must fit within the "pitch" allowed for their associated sense amplifier, as any excess size will directly affect the chip size, and thus the manufacturing cost of the integrated circuit; indeed, the capacitance added to the data bus by the drivers themselves, where multiple drivers are driving the same bus, can outweigh the benefit of the larger drive capacity. Furthermore, in some cases the R-C load of the data bus may be too great for any reasonably sized driver to meet the desired switching time from rail to rail.

In addition, certain integrated circuits have data line pairs for the communication of data by way of a differential signal, and which are precharged and equilibrated to a particular voltage. During long cycle operations, however, noise and other effects can cause these precharged lines to charge or discharge to an undesirable voltage, causing a delay in the next operation in charging (or discharging) the differential lines. IEEE Journal of solid State Circuits vol. SC-21, No. 5, October 1986, paged 586-691 Kayano et al describes a 25-ns 256K CMOS static RAM. It relates in particular to the implementation of a short bit-line structure and the precharging of the data bus. The document discloses a sense amplifier connected to an inverter. The inverter comprises a pull-up transistor connected between a high voltage and an output node and a pull-down transistor connected between a low voltage, and the output node. The output node of the inverter is connected through a pass gate to a bus. The conductivity of the pass gate is controlled by an enable signal. The precharging of the bus is achieved by means of the inverter which receives its input from the bus and whose output is selectively connected to the bus.

US 5,062,082 discloses a precharge circuit in which a first data line is connected to a high voltage through a first transistor, a second data line is connected to a high voltage through a second transistor, and the first data line is connected to the second data line through a third transistor. The first, second and third transistors become conductive in response to an address transition.

It is therefore an object of the present invention to provide a circuit and technique for maintaining the bias of differential data lines, without requiring activation of a driver circuit.

It is also an object of this invention to provide a technique for precharging data bus conductors, between cycles, prior to the application of a data signal thereto.

It is a further object of this invention to provide such a technique which is closely matched to the construction of the data bus conductors.

It is a further object of this invention to provide such techniques incorporating a dummy data bus conductor, and in which floating conditions on the dummy data bus conductor are avoided.

It is a further object of this invention to provide such techniques which precharge the data bus conductor near the trip point of the output stage, without risking oscillations.

Other objects and advantages of the present invention will become apparent to those of ordinary skill in the art having reference to the following specification together with the drawings.

The invention may be implemented in an integrated circuit, such as a memory, which has differential data lines precharged or equilibrated toward a particular voltage, by providing self-biasing circuits for each data line. The self-biasing is provided to prevent the differential and complementary data conductors from floating to undesired voltages during long equilibration operations. The data conductors may be received by a tristatable output stage which is disabled during precharge and equilibration, and which matches the point to which the self-biasing circuits maintain the data lines.

The invention may further be implemented in an integrated circuit, such as a memory, by providing dummy data conductors in parallel with the true data conductors in the data bus. Each dummy data conductor is preferably constructed to physically resemble its corresponding true data conductor, and receives the logical complement of the data state presented on the true data conductor in a read operation. Prior to the next cycle, the true and dummy data conductors are connected together so that, by way of charge sharing, the true data conductor is precharged to a midlevel voltage, thus reducing the switching time prior to the next cycle. A self-biasing circuit is provided to prevent the true and dummy data conductors from floating to undesired voltages during long equilibration operations. Each true data conductor is received by a tristatable output stage which is disabled during precharge and equilibration, thus preventing oscillations in the output circuitry which may also occur during long equilibrations.
According to one aspect of the present invention there is provided an integrated circuit, comprising;
functional circuitry;
a data bus comprising first and second data conductors, for communicating a differential voltage thereon, said differential voltage being comprised of a first voltage on said first data conductor and a second voltage on said second data conductor;
first and second data drivers, each having an input coupled to said functional circuitry for receiving information therefrom, and having an output, for driving said first and second data conductors to a differential voltage corresponding to said information;
means for generating a control signal upon the initiation of a memory operation;
circuitry, for establishing and maintaining said first and second data conductors at a voltage intermediate of said first and second voltages, comprising;
a transistor having a conduction path connected between said first and second data conductors, and having a control terminal for receiving said control signal, for connecting said first and second data conductors together, when at said differential voltage, responsive to said control signal; and
first and second self-biasing circuits coupled to said first and second data conductors, respectively, each biased by first and second bias voltages, each operable together with said transistor to establish and maintain its associated data conductor at a voltage intermediate of said first and second voltages, each self-biasing circuit comprising:
a pull-up transistor having a conduction path coupled between its associated data conductor and said first bias voltage, and having a control terminal connected to its associated data conductor, said pull-up transistor being of a conductivity type such that it is conductive responsive to its associated data conductor being at a voltage near said second bias voltage; and
a pull-down transistor having a conduction path coupled between its associated data conductor and said second bias voltage, and having a control terminal connected to its associated data conductor, said pull-down transistor being of a conductivity type such that it is conductive responsive to its associated data conductor being at a voltage near said first bias voltage.

According to another aspect of the present invention there is provided a method of operating an integrated circuit, said integrated circuit including functional circuitry coupled to a data bus having first and second differential data conductors therein upon which said functional circuitry presents a differential voltage resulting from an operation by said functional circuitry, one of said pair of data conductors connected to an output stage, comprising:
driving said differential data conductors with a differential voltage corresponding to the result of the operation of the functional circuitry said first data conductor being driven to a first voltage and said second conductor being driven to a second voltage;
after said driving step, isolating said data conductors from said functional circuitry;
after said isolating step, establishing and maintaining said first and second data conductors at a voltage intermediate of said first and second voltages by:
connecting said pair of data conductors, at said differential voltage, to one another;
responsive to said first data conductor having a voltage near a first bias voltage, turning on a transistor connected between said first data conductor and a second bias voltage; and
responsive to said first data conductor having a voltage near said second bias voltage, turning on a transistor connected between said first data conductor and said first bias voltage.

Some embodiments of the invention will now be described by way of example and with reference to the accompanying drawings in which:

Figure 1 is an electrical diagram, in block form, illustrating the architecture of a memory integrated circuit into which the preferred embodiment of the invention may be incorporated.

Figure 2 is an electrical diagram, in schematic form, of one of the sense amplifiers in the memory circuit of Figure 1.

Figure 3 is an electrical diagram, in schematic form, of the combination of one of the data conductors and its associated dummy data conductor according to the preferred embodiment of the invention.

Figure 4 is a timing diagram illustrating the operation of the preferred embodiment of the invention.

Figure 5 is an electrical diagram, in block form, illustrating the connection of the data conductors and dummy data conductors to the data driver circuits for each array block.

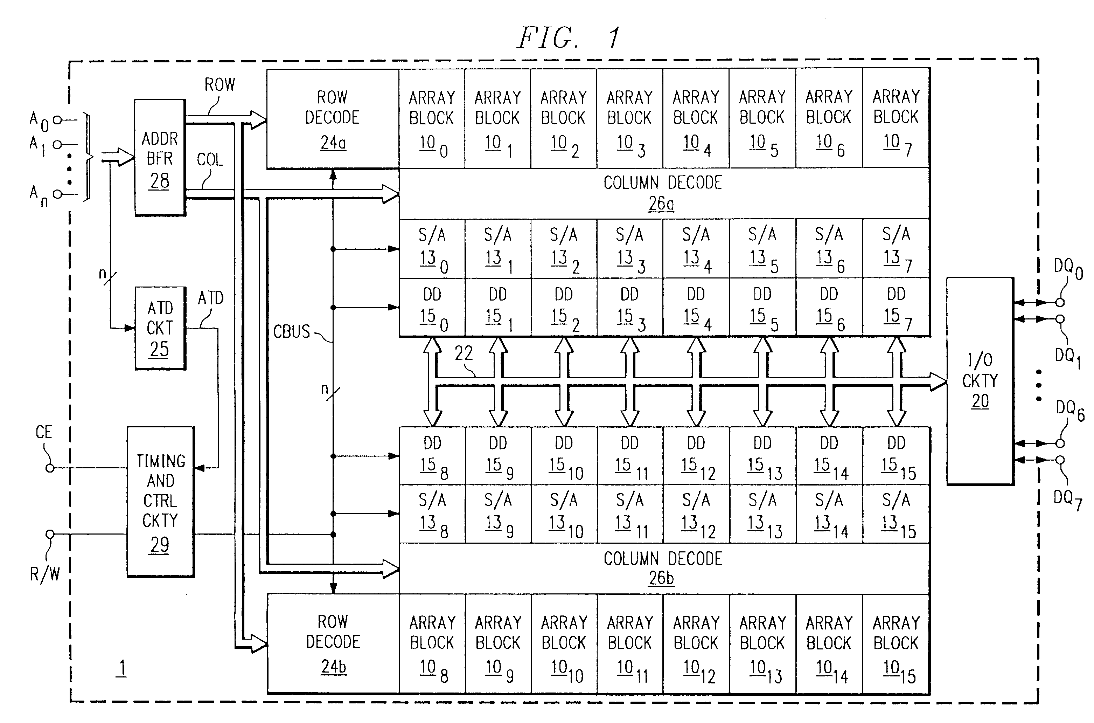

Referring now to Figure 1, an example of an integrated circuit into which the preferred embodiment of the invention is implemented will be described. In this example, memory 1 is a static random access memory (SRAM) of otherwise conventional architecture, having its memory cells in multiple blocks 10 which are shown, in Figure 1, according to an example of their physical location in such a memory. It is contemplated that integrated circuits of other types which utilize long data conductors may also benefit from the present invention, such integrated circuits including microprocessors, logic devices, and other types of memories including read-only memories, FIFOs, DRAMs and the like.

As is conventional, memory cells in memory 1 are arranged in rows and columns, and are selected according to an address signal received at address terminals A₀ through Aₙ. Address terminals A₀ through Aₙ are connected to address buffers 28, which buffer the received address signal and communicate a portion of the address signal to row decoders 24a, 24b on bus ROW, and communicate the remainder to column decoders 26a, 26b on bus COL. Row decoders 24a, 24b select a row of memory cells by enabling the selected word line, in the conventional manner, and are thus preferably located along a side of the memory array blocks 10. Column decoders 26a, 26b, in this example, select eight memory cells in the selected row to be sensed by a sense amplifier 13 according to the column portion of the address.

In memory 1 according to this example, the memory cells are grouped into sixteen array blocks 10₀ through 10₁₅. This partitioning of the memory into sixteen array blocks 10 is particularly beneficial in low power memories, such as may be used in portable computers, as only the block 10 in which the selected memory cells are located need be enabled during a cycle. Selection of the block may be done according to one of the row address bits (indicating upper or lower half) and to four of the column address bits (indicating one of sixteen array blocks 10 to be selected). Further reduction in the active pcwer may be obtained by the implementation of latched row line repeaters between array blocks 10, as described in the copending application European Publication Number 0478253.

Memory 1, as in the case of most modern SRAMs and DRAMs, includes some amount of dynamic operation, such as precharging and equilibration of certain nodes (e.g., bit lines) at particular points in the memory cycle. Initiation of the cycle in SRAM 1 occurs by way of address transition detection, performed by address transition detection (ATD) circuit 25. ATD circuit 25 is connected to each of the address inputs A₀ through Aₙ, preferably prior to address buffers 28 (as shown), and generates a pulse on line ATD responsive to detecting a transition at any one or more of address inputs A₀ through Aₙ, such a pulse useful in controlling the internal operation of memory 1 in the conventional manner, and also in the manner to be described hereinbelow.

Other internal operational functions are controlled by timing and control circuitry 29, which receives the signal on line ATD from ATD circuit 25, and which also receives certain external control signals such as the chip enable signal at terminal CE, and the read/write select signal at terminal R/W. Timing and control circuitry 29 generates various control signals based on these inputs, for control of the various functions within memory 1 in the conventional manner. As shown in Figure 1, control bus CBUS is connected to sense amplifiers 13 and data drivers 15, by which such signals as the GEQT, GEQC, SAEQ_, SCLK, ISO signals described hereinbelow are generated and communicated within memory 1.

Memory 1 in this example is of the byte-wide type, and as such it has eight input/output terminals DQ₀ through DQ₇ at which output data is presented during a read operation, and at which input data is received during a write operation. Input/output circuitry 20 is connected between data bus 22 and terminals DQ, and includes conventional input and output buffers connected thereto. A preferred type of output buffer is described in European Patent Publication Number 0547891.

Each of array blocks 10₀ through 10₁₅ is associated with a corresponding group of sense amplifiers 13₀ through 13₁₅, as shown in Figure 1. In this example, eight individual sense amplifiers 13 are included within each group of sense amplifiers 13₀ through 13₁₅, one sense amplifier 13 for each of the eight bits to be communicated on internal data bus 22 from the selected one of array blocks 10₀ through 10₁₅. Groups of data drivers 15₀ through 15₁₅ are each associated with a corresponding group of sense amplifiers 130 through 13₁₅ for receiving the data signal therefrom and for driving internal data bus 22 therewith; individual data drivers 15 are associated with individual sense amplifiers 13 in each group, one data driver 15 for driving each line in data bus 22.

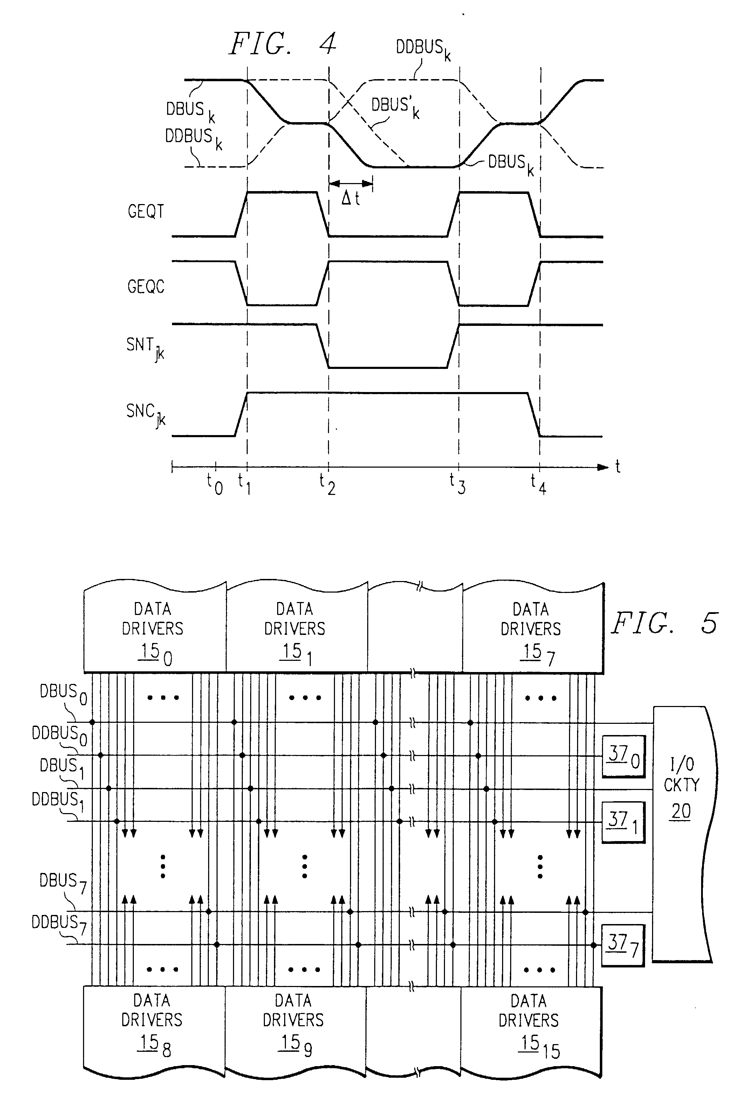

In this example, the memory array is also divided into halves, with array blocks 10₀ through 10₇ in one array half and array blocks 10₈ through 10₁₅ in the other half. Internal data bus 22 runs the length of the array halves, and is located therebetween as shown in Figures 1 and 5. As shown in Figure 5, data bus 22 includes data conductors DBUS₀ through DBUS₇, each associated with an input/output terminal DQ₀ through DQ₇ (and coupled thereto via input/output circuitry 20). Each individual data conductor DBUSₖ is connected to a corresponding data driver 15 in each of the sixteen data driver groups 15₀ through 15₁₅ of the sixteen array blocks 10₀ through 10₁₅. For a read/write memory such as memory 1, a separate input data bus can be used to communicate input data to be written to the selected memory cells, in the conventional manner. Alternatively, the input data may also be communicated along data bus 22, as is conventional for some memory designs.

Data bus 22 also includes eight dummy data conductors DDBUS₀ through DDBUS₇, each of which are also connected to a corresponding data driver 15 in each of the sixteen data driver groups 15₀ through 15₁₅ of the sixteen array blocks 10₀ through 10₁₅. Dummy data conductors DDBUS₀ through DDBUS₇ are used for precharging of data bus 22, as will be described hereinbelow, and not for communication of a data state; as such, dummy data conductors DDBUS₀ through DDBUS₇ are not coupled to input/output circuitry 20 for communication of data to and from terminals DQ, but instead are terminated by terminations 37, as shown in Figure 5. To ensure proper precharge of data conductors DBUS, each of dummy data conductors DDBUS preferably physically resembles one of data conductors DBUS, having substantially the same length and cross-sectional area, and being formed of the same material.

In the arrangement of Figures 1 and 5, it is therefore apparent that each of the data conductors DBUS in data bus 22 will be relatively long, running much of the length of the chip in order to connect to data drivers 15 for each of the array blocks 10. As such, the series resistance of each data bus conductor DBUS can be quite high, even when formed of metal such as aluminum, especially in high density circuits. For example, each data bus conductor DBUS can be on the order of 13,200 *µ* long, with a cross-sectional area of on the order of 1.1 *µ*₂; an aluminum conductor of these dimensions will have a series resistance of on the order of 550 Ω. In addition, with many (e.g., sixteen) data drivers 15 connected to each data bus conductor DBUS, as well as the input/output circuitry 20 connected thereto, the capacitance associated with a single data bus conductor DBUS can be on the order of 4 pF. The R-C load of data bus conductors DBUS can thus be quite significant, requiring on the order of 2.2 nsec to switch from rail-to-rail (5 volts) for typical on-chip drivers, and thus directly and significantly impacts the read access time of the memory. Due to the size of write drivers available in input/output circuitry 20, and also where a separate input data bus is provided, the write time may not be affected to the same degree; in addition, the duration of the write operation is generally not as critical a parameter in a high speed memory as the read access time. As will be described hereinbelow, use of dummy data conductors DDBUS according to the present invention can provide significant reduction in the access time of memory 1.

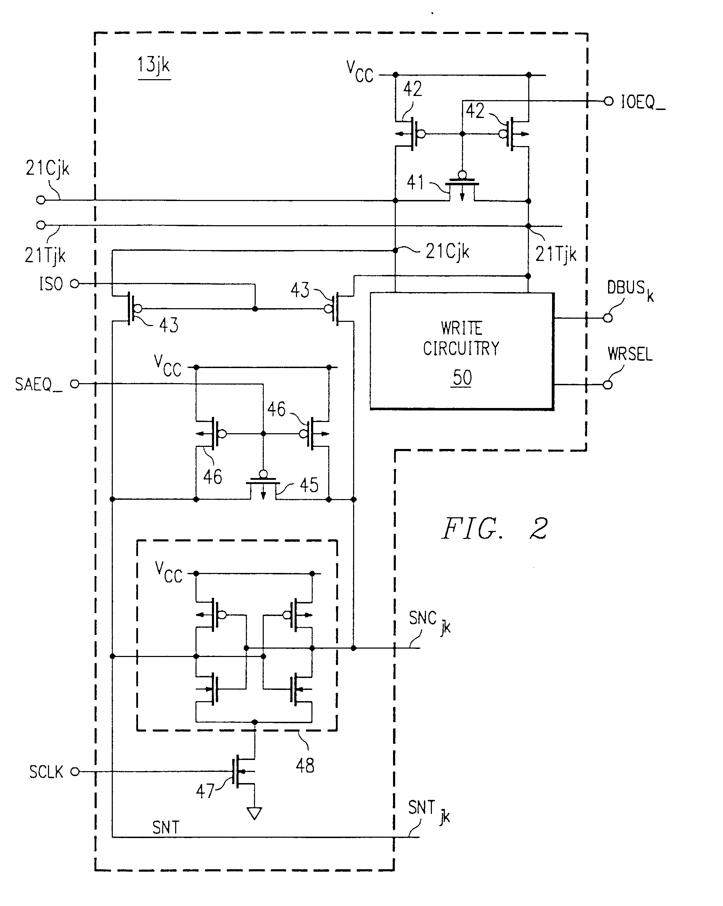

Referring now to Figure 2, the construction of an example of one of sense amplifiers 13 will now be described in detail. Further detail concerning this example of sense amplifier 13, and its operation relative to column decoder 26, is described in European Patent Publication No 0490651.

Sense amplifier 13ⱼₖ of Figure 2 is the sense amplifier associated with array group 10ⱼ and input/output terminal DQₖ.

Of course, other sense amplifier designs may alternatively be used in connection with the present invention. One example of such an alternative design is a multiple stage sense amplifier scheme, including a level shifter stage connected to each of the differential bit lines for implementing a DC level shift thereon, followed by a combination of a current mirror and differential sense amplifier (the differential sense amplifier similar as that shown in Figure 2). Other sense amplifier configurations and implementations may similarly be used, in the alternative to that shown in Figure 2.

In the example of Figure 2, complementary input/output lines 21Tⱼₖ, 21Cⱼₖ (T for true and C for complement) are coupled, via column decoder 26, to the bit lines of the selected memory cell in array group 10ⱼ associated with input/output terminal DQₖ; in a read operation, input/output lines 21Tⱼₖ, 21Cⱼₖ communicate data from the selected memory cell, and in a write operation input/output lines 21Tⱼₖ, 21Cⱼₖ communicate data to the selected memory cell. Input/output lines 21Tⱼₖ, 21Cⱼₖ are each connected to the drain of a p-channel precharge transistor 42; the sources of transistors 42 are both connected to the precharge voltage for the input/output lines 21Tⱼₖ, 21Cⱼₖ, which in this case is V_{cc}. Input/output lines 21Tⱼₖ, 21Cⱼₖ are also connected to one another by p-channel equilibration transistor 41. The gates of transistors 41 and 42 are connected to line IOEQ_ , which is generated by timing control circuitry 29 responsive to an address transition detected by ATD circuit 25, or to such other events during the cycle for which equilibration of input/output lines 21 are desired.

On the read side of sense amplifier 13ⱼₖ, input/output lines 21Tⱼₖ, 21Cⱼₖ are each connected to a p-channel pass transistor 43, each of pass transistors 43 having its gate controlled by an isolate signal ISO. Accordingly, input/output lines 21Tⱼₖ, 21Cⱼₖ may be isolated from the read circuitry by line ISO at a high logic level, and may be connected thereto by line ISO at a low logic level. The complementary lines on the opposite side of pass transistors 43 from input/output lines 21Tⱼₖ and 21Cⱼₖ are referred to in Figure 2 as sense nodes SNTⱼₖ and SNCⱼₖ, respectively.

Sense nodes SNTⱼₖ, SNCⱼₖ are also preferably precharged and equilibrated (in this example, to the voltage V_{cc}) during the appropriate portion of the cycle, as sense amplifier 48 within sense amplifier 13 operates in dynamic fashion, as will be described hereinbelow. P-channel precharge transistors 46 each have their source-to-drain paths connected between V_{cc} and sense nodes SNTⱼₖ and SNCⱼₖ, respectively. Equilibration transistor 45 is a p-channel transistor having its source-to-drain path connected between sense nodes SNTⱼₖ and SNCⱼₖ. The gates of transistors 45 and 46 are all controlled by line SAEQ_ which, when at a low level, precharges and equilibrates sense nodes SNTⱼₖ and SNCⱼₖ in similar manner as input/output lines 21Tⱼₖ and 21Cⱼₖ, described above, and as the bit lines in array block 10ⱼ.

Sense amplifier 48 is a conventional CMOS latch consisting of cross-coupled inverters therewithin; the inputs and outputs of the cross-coupled latches are connected to sense nodes SNTⱼₖ, SNCⱼₖ in the conventional manner. N-channel pull-down transistor 47 has its source-to-drain path connected between the sources of the n-channel transistors in sense amplifier 48 and ground, and has its gate controlled by line SCLK.

Pull-down transistor 47 provides dynamic control of sense amplifier 48, so that the sensing of sense nodes SNTⱼₖ, SNCⱼₖ is performed in dynamic fashion. As is well known in dynamic RAMs, the dynamic sensing in this arrangement is controlled with transistor 47 initially off at the time that pass transistors 43 connect sense nodes SNTⱼₖ, SNCⱼₖ to input/output lines 21Tⱼₖ, 21Cⱼₖ, respectively; during this portion of the cycle, sense amplifier 48 is presented with a small differential voltage between sense nodes SNTⱼₖ and SNCⱼₖ. After development of this small differential voltage, line SCLK is driven high, so that the sources of the pulldown transistors in sense amplifier 48 are pulled to ground. This causes sense amplifier 48 to develop a large differential signal on sense nodes SNTⱼₖ and SNCⱼₖ, and latch the sensed state thereof.

As will be apparent from the description hereinbelow, each sense amplifiers 13ⱼₖ associated with the same data conductor DBUSₖ are coupled to one another in essentially wired-OR fashion. Accordingly, the control signals ISO, SAEQ_ , and SCLK which are presented to the read side of sense amplifier 13ⱼₖ are preferably generated by column decoder 26 in conjunction with timing control circuitry 29. Such generation of these control signals provides that the ones of sense amplifier 13ⱼₖ associated with unselected array blocks 10 are not enabled (by lines ISO maintained high, and lines SAEQ_ and SCLK maintained low) so as to maintain their sense nodes SNTⱼₖ and SNCⱼₖ equilibrated and precharged to V_{cc}, preventing bus conflict on data bus 22.

On the write side of sense amplifier 13ⱼₖ, write circuitry 50ⱼₖ receives input data from data conductor DBUSₖ associated therewith, and a control signal on line WRSEL from timing and control circuitry 29. In write operations, write circuitry 50ⱼₖ presents the data state of data conductor DBUSₖ in complementary fashion on input/output lines 21Tⱼₖ, 21Cⱼₖ in the conventional fashion. The above-referenced copending application S.N. 627,049 describes a preferred example of write circuitry 50ⱼₖ, in further detail.

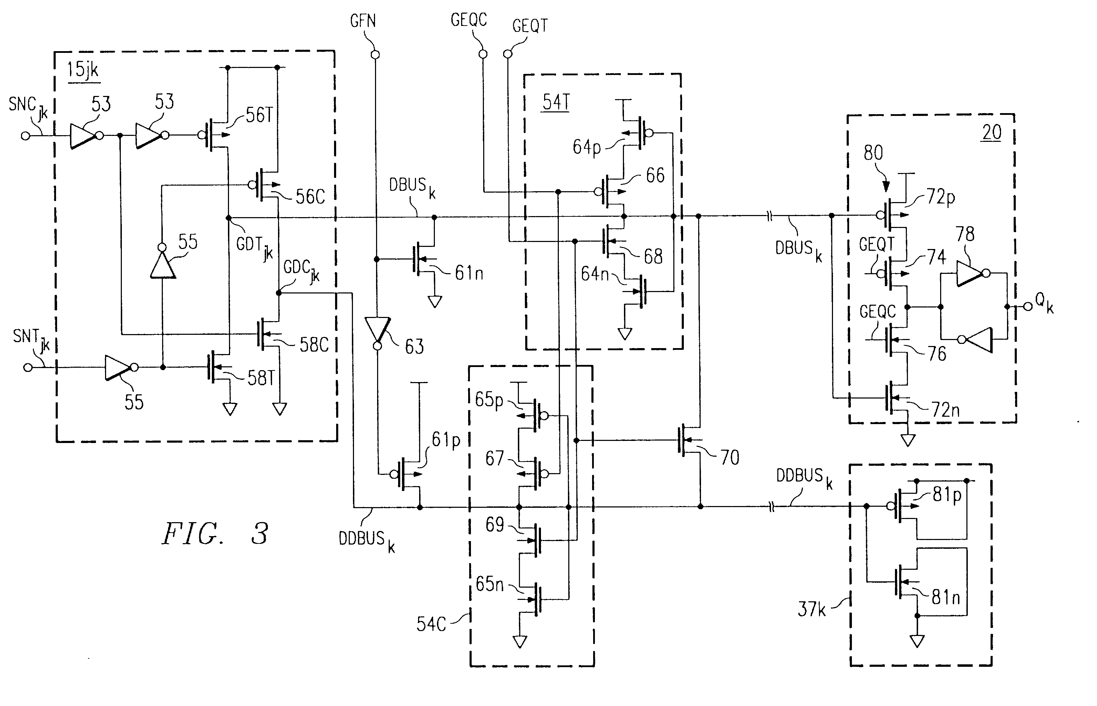

Referring now to Figure 3, the construction and operation of one of data drivers 15 according to the preferred embodiment of the invention will now be described in detail. Data driver 15ⱼₖ of Figure 3 is associated with input/output terminal DQₖ and with array block 10ⱼ, and accordingly receives, as inputs, nodes SNTⱼₖ and SNCⱼₖ from sense amplifier 13ⱼₖ of Figure 2.

Nodes SNTⱼₖ and SNCⱼₖ are received at inputs of tristate data driver 15ⱼₖ. According to this embodiment of the invention, and as will become apparent hereinbelow, data conductors DBUS and dummy data conductors DDBUS must each be driven by tristate drivers, in order to enable their precharging by way of charge sharing with one another. In addition, since multiple data drivers 15 drive the same data conductors DBUS (and dummy data conductors DDBUS), each of data drivers 15 must have a high-impedance state to avoid bus contention problems. In prior memory configurations, this is generally accomplished by merely turning off the sense amplifiers. However, since sense amplifiers 13 in this example precharge their output nodes SNT, SNC high (as is the case in many memory circuits), this state does not necessarily prevent the active driving of data conductors DBUS.

Other prior schemes, in which sense amplifier outputs are precharged to the same voltage, have included an enable signal for controlling tristate data drivers. In these prior schemes, however, an additional signal line must be provided for each data driver, as well as the necessary circuitry for generating this additional signal and also a relatively complex data driver capable of responding to the additional signal. Still other conventional schemes included a series pass gate between the sense amplifier and the internal data bus, such a pass gate adding its propagation delay time in the critical read path, and thus being undesirable.

Data driver 15ⱼₖ according to the preferred embodiment of the invention provides tristate capability in a simple and effective manner. Driver 15ⱼₖ includes two push-pull driver circuits therein, for driving complementary nodes GDTⱼₖ and GDCⱼₖ, respectively, which in turn are connected to data conductor DBUSₖ and dummy data conductor DDBUSₖ, respectively. These push-pull drivers each include p-channel pull-up transistor 56 and n-channel pull-down transistor 58, having their source/drain paths connected in series between V_{cc} and ground; the output of each of the drivers is, in the conventional sense, at the common drain of transistors 56 and 58. In this example, the drains of transistors 56T, 58T at node GDTⱼₖ are connected to data conductor DBUSₖ, and the drains of transistors 56C, 58C at node GDCⱼₖ are connected to dummy data conductor DDBUSₖ. Referring back to Figures 1 and 5, similar nodes GDT, GDC in the other fifteen data drivers 15 are similarly connected to data conductor DBUSₖ and dummy data conductor DDBUSₖ, thus necessitating the ability of drivers 15 to have a high-impedance output state.

Node SNCⱼₖ is connected to the gate of pull-up transistor 56T after inversion by two inverters 53, and is connected to the gate of pull-down transistor 58C after inversion by one of inverters 53. Conversely, node SNTⱼₖ is connected directly to the gate of pull-up transistor 56C via two inverters 55, and to the gate of pull-down transistor 58T after inversion by one of inverters 55. The connection of two inverters 53, 55 to nodes SNCⱼₖ and SNTⱼₖ, respectively, provides a balanced load to the differential output of sense amplifier 13ⱼₖ.

In operation, when sense amplifier 13ⱼₖ is on, and senses a logic "one" state in the selected memory cell, node SNTⱼₖ will be high and node SNCⱼₖ will be low. Accordingly, transistors 58T and 56C will both be off, and transistors 56T and 58C will both be on, driving node GDTⱼₖ to a high logic level and driving node GDCⱼₖ to a low level. Conversely, when sense amplifier 13ⱼₖ senses a logic "zero" state, node SNTⱼₖ will be low and node SNCⱼₖ will be high; this turns on transistors 58T, 56C, turns off transistors 56T, 58C, and thus drives node GDTⱼₖ low and node GDCⱼₖ high.

As described hereinabove, sense amplifier 13ⱼₖ is turned off when its array block 10ⱼ is not selected (or during a write operation). In this embodiment, sense amplifier 13ⱼₖ drives both of its nodes SNTⱼₖ, SNCⱼₖ high when disabled, by operation of transistors 45, 46 being turned on and transistors 43 and 47 being turned off (see Figure 2). A high logic level on node SNCⱼₖ turns off transistors 56T, 58C, and a high logic level on node SNTⱼₖ turns off transistors 56C, 58T. Accordingly, both pull-up transistors 56 and both pull-down transistors 58 are turned off by sense amplifier 13ⱼₖ being turned off, placing nodes GDTⱼₖ and GDCⱼₖ at their output in a high-impedance state. This tristate condition is therefore obtained without requiring the generation and communication of an additional signal, but is accomplished as a response to the precharged condition of sense amplifier 13ⱼₖ. Accordingly, to enable precharge and equilibration of data conductors DBUS and dummy data conductors DDBUS, driver 15ⱼₖ is placed in a high impedance state during precharge and equilibration, as signal SAEQ_{_} is at a low logic level during this time (placing both nodes SNTⱼₖ, SNCⱼₖ high at that time).

Data bus conductors DBUS and dummy data bus conductors DDBUS can all be biased to known complementary voltages, by way of transistors 61n, 61p and signal GFN. A single placement of transistors 61n, 61p for each data bus conductor DBUSₖ and dummy data bus conductor DDBUSₖ may be sufficient, or alternatively multiple placements of transistors 61n, 61p may be used. Data bus conductor DBUSₖ is connected to the drain of n-channel transistor 61n, which has its source connected to ground and its gate connected to line GFN; dummy data bus conductor DDBUSₖ is connected to the drain of p-channel transistor 61p, which has its source biased to V_{cc} and its gate connected to line GFN via inverter 63. Accordingly, when line GFN when is at high logic level, data conductor DBUSₖ is biased to ground, and dummy data conductor DDBUSₖ are biased to V_{cc}; conversely, when line GFN is low, transistors 61n, 61p are both off and do not affect the level of data bus conductors DBUSₖ and dummy data bus conductors DDBUSₖ, respectively, as is case during normal operation. Line GFN is preferably driven high during write operations (where a separate internal input data bus is used) and during such times as memory 1 is deselected, so that a complementary relationship between each data conductor DBUS and its dummy data bus conductor DDBUS is maintained at all times.

Memory 1 further includes self-biasing circuits 54T, 54C, each connected to data conductor DBUSₖ and dummy data conductor DDBUSₖ, respectively, to maintain these lines from floating during equilibration and precharge. A single self-biasing circuits 54T, 54C may be implemented for each data conductor DBUSₖ and dummy data conductor DDBUSₖ in memory 1, or alternatively multiple self-biasing circuits 54T, 54C may be used for each data conductor DBUSₖ and dummy data conductor DDBUSₖ, depending upon the drive required to maintain the precharged state thereof. As is well known, noise can capacitively couple to floating nodes in integrated circuits, such that the potential of such nodes can rise or fall to any potential, especially during long equilibration periods such as can occur if the addresses received by memory 1 are unstable. As will be apparent hereinbelow, floating of data conductors DBUS to a voltage significantly different from the preferred mid-level voltage can push out the access time of the memory if the next data state to be driven is the opposite from that to which one or more of data conductors DBUS floated.

Self-biasing circuit 54T includes p-channel transistors 64p and 66 which have their source/drain paths connected in series between V_{cc} and data bus conductor DBUSₖ, and n-channel transistors 64n and 68 which have their source/drain paths connected in series between data bus conductor DBUSₖ and ground. The gates of transistors 64p and 64n are both connected to data bus conductor DDBUSₖ to maintain its precharged state as described hereinbelow.

The gate of p-channel transistor 66 is connected to line GEQC, which is a precharge signal active at a low logic level, and the gate of n-channel transistor 68 is connected to line GEQT, which is a precharge signal active at a high logic level. Lines GEQT and GEQC (which are the logical complements of one another), are generated by timing and control circuitry 29 as high and low logic level pulses, respectively, which control the initiation and duration of the precharge of data conductors DBUS. In this embodiment of the invention, lines GEQT, GEQC are derived by timing and control circuitry 29 from the pulse on line ATD generated by ATD circuit 25 responsive to detection of a transition at one or more of address terminals A₀ through Aₙ, and communicated along control bus CBUS. Derivation of the precharge signals from address transition detection enables precharging of data conductors DBUS at the appropriate early portion of the cycle, since a new memory cycle in an SRAM such as memory 1 begins with receipt of a new address. Such precharge at the beginning of the cycle, rather than at the end, is of course preferred for SRAMs since the duration of the cycle is indeterminate.

Self-biasing circuit 54C is similarly constructed, with p-channel transistors 65p, 67 having their source/drain paths connected in series between dummy data bus conductor DDBUSₖ and V_{cc}, and with n-channel transistors 65n, 69 having their source/drain paths connected in series between dummy data bus conductor DDBUSₖ and ground. The gates of transistors 65p, 65n are connected to dummy data bus conductor DDBUSₖ, and the gates of transistors 67, 69 are connected to precharge lines GEQC, GEQT, respectively.

In operation, self-biasing circuits 54T, 54C are enabled only during the precharge and equilibration operation, when line GEQT is high and line GEQC is low. When enabled, the voltage at data bus conductor DBUSₖ (for the case of self-biasing circuit 54T) will determine the state of transistors 65p or 65n. As noted hereinabove and as will be described hereinbelow, data conductor DBUSₖ is not actively driven during precharge. Accordingly, if noise couples to data conductor DBUSₖ which causes its voltage to rise, transistor 64n will tend to turn on harder, and discharge data conductor DBUSₖ until such time as its voltage turns off transistor 64n (or turns it on to a lesser degree than transistor 64p is turned on). Self-biasing circuit 54C operates in the same manner relative to dummy data conductor DDBUSₖ. Accordingly, self-biasing circuits 54T, 54C keep data conductors DBUS and dummy data conductors DDBUS from floating during precharge, particularly during long precharge and equilibration operations.

The terminal end of data conductor DBUSₖ is received by input/output circuitry 20, specifically at the gates of p-channel pull-up transistor 72p and n-channel pull-down transistor 72n in output stage 80. The source/drain paths of transistors 72p, 72n are connected in series, between V_{cc} and ground, with the source/drain paths of transistors 74, 76. The gate of p-channel transistor 74 is connected to line GEQT, and the gate of n-channel transistor 76 is connected to line GEQC, and their drains are connected together. Latch 78, consisting of cross-coupled inverters, has its input connected to the drains of transistors 74, 76; the output of latch 78, node Qₖ is forwarded to the output buffers of memory 1 for presentation thereat.

In operation, during precharge and equilibration (line GEQT high and line GEQC low), the state of data conductor DBUS is isolated from affecting node Qₖ, as transistors 74, 76 are both turned off. During normal operation, transistors 74, 76 are on and output stage 80 operates as a conventional CMOS inverter. Since transistors 74, 76 in output stage 80 are turned off during the precharge and equilibration period, output stage 80 is disabled from responding to the state of data conductor DBUSₖ. This allows data conductor DBUSₖ to be safely precharged to a voltage near the trip point of output stage 80, without resulting in oscillations of the output circuitry as would otherwise occur if output stage 80 remained enabled during precharge.

It is preferred that self-biasing circuit 54T (and self-biasing circuit 54C, for symmetry) be constructed in such a manner that its bias point is near the trip point of output stage 80 driven by data conductor DBUS. As such, the push-pull construction of self-biasing circuit 54T matches the construction of output stage 80. In order to minimize the current drawn through self-biasing circuits 54T, 54C, it is preferred that the sizes of the transistors therein be scaled from those in output stage 80. For example, the channel widths of the transistors in self-biasing circuits 54T, 54C are preferably on the order of one-fourth of the transistors in output stage 80; the channel lengths in self-biasing circuits 54T, 54C are preferably longer, for example by a factor of three, than in output stage 80. The bias current provided by self-biasing circuits 54T, 54C is therefore quite small, but is sufficient to keep data conductors DBUS from floating to a voltage significantly different from its precharged level.

It is contemplated that self-biasing circuits 54T, 54C may also be beneficial when implemented in other data bus arrangements, for example a differential data bus where each bit of data is communicated by a differential (or complementary) signal carried on a pair of data bus lines. The advantages of maintaining the precharged level on differential conductors as described hereinabove may thus be obtained in these arrangements, as well.

Equilibration transistor 70 has its source/drain path connected between data conductor DBUSₖ and dummy data conductor DDBUSₖ, and has its gate connected to line GEQT (transistor 70 being n-channel). Transistor 70 is therefore turned on during precharge (line GEQT high), and will effect the precharging of data conductor DBUS by way of charge sharing, as will be described hereinbelow. Alternatively, a p-channel transistor with its gate controlled by line GEQC may be used in place of, or in parallel with, n-channel equilibration transistor 70. In addition, it may be preferable in some cases to provide multiple transistors 70 for each data conductor DBUSₖ and dummy data conductor DDBUSₖ, for example one transistor 70 at each end thereof; of course, depending upon the size of transistor 70, a single placement may be sufficient.

As illustrated in Figure 5, dummy data conductors DDBUS are terminated by terminations 37. Terminations 37 provide a load to dummy data conductor DDBUS which matches that presented by output stage 80 to data conductors DBUS. In the example of Figure 3, termination 37ₖ includes p-channel transistor 81p which has its source and drain connected together to V_{cc}, and n-channel transistor 81n which has its source and drain connected together to ground; the gates of transistors 81p and 81n are connected to dummy data conductor DDBUSₖ. Termination 37ₖ thus presents the equivalent capacitance (i.e., the gate capacitance of a CMOS inverter) to dummy data conductor DDBUSₖ that output stage 80 presents to data conductor DBUSₖ.

Referring now to Figure 4, the operation of the preferred embodiment of the invention will now be described in detail. At time t₀ in this example, data conductor DBUSₖ is at a high level and dummy data conductor DDBUSₖ is at a low level, due to the complementary operation of tristate driver 15ⱼₖ as a result of node SNTⱼₖ at a high level and node SNCⱼₖ at a low level. Also at time t₀, since the access of the selected memory cell has been active for some time, precharge lines GEQT and GEQC are low and high, respectively.

The precharge and equilibration operation begins at time t₁, which is a specified time after the beginning of the next cycle; as noted hereinabove, a new cycle in memory 1 can be initiated by a transition at one or more of address terminals A₀ through Aₙ, at the end of a write operation, or upon receipt of a chip enable signal. Responsive to detection of this transition, at time t₁, line GEQT is driven to a high level, line GEQC is driven low; also at this time, sense amplifier 13ⱼₖ is turned off by way of lines SAEQ_{_} and SCLK, so that node SNCⱼₖ goes to a logic high level. With both nodes SNTⱼₖ and SNCⱼₖ high, tristate driver 15ⱼₖ enters a high impedance state.

Prior to time t₁, data conductor DBUSₖ and dummy data conductor DDBUSₖ (since all other sense amplifiers 13 and tristate drivers 15 are in a high impedance state, having not been selected in this cycle) are at high and low logic levels, respectively. As line GEQT goes to a high level at time t₁, transistor 70 turns on, connecting data conductor DBUSₖ to dummy data conductor DDBUSₖ. Since tristate driver 15ⱼₖ enters its high impedance state at this time and no longer actively drives either data conductor DBUSₖ and dummy data conductor DDBUSₖ, transistor 70 initiates charge sharing between data conductor DBUSₖ and dummy data conductor DDBUSₖ. Data conductor DBUSₖ and dummy data conductor DDBUSₖ thus discharge and charge, respectively, to a common potential near the mid-level between high and low logic levels. Precharge of data conductor DBUSₖ is then complete.

Also during this time, output stage 80 is disabled from responding to the precharged state of data conductor DBUSₖ, as transistors 74, 76 therein are held off by lines GEQC, GEQT, respectively.

For purposes of clarity, the duration of precharge and equilibration between times t₁ and t₂, as illustrated in Figure 4, is relatively short. As such, the voltage of data conductor DBUSₖ and dummy data conductor DDBUSₖ is not likely to significantly drift from its precharged level as a result of capacitively coupled noise. However, in memory 1 as in many SRAM and DRAM memory devices, the precharge and equilibration period can be quite long, for example on the order of microseconds. In an SRAM device where precharge and equilibration are triggered by address transition detection, such as memory 1, a long precharge and equilibration period can result from unstable, or high frequency, address signals applied to memory 1. In clocked circuits, such as FIFOs, DRAMs, embedded memories in microprocessors, microprocessors themselves, and the like, a low frequency or long duty cycle clock signal will cause a long precharge and equilibration period.

Self-biasing circuits 54T, 54C prevent data conductors DBUS and dummy data conductors DDBUS from drifting far from their precharged voltage, even during long precharge and equilibration periods. As noted hereinabove relative to Figure 3, if data conductor DBUSₖ receives noise which causes it to drift upward, transistor 64n (and transistor 65n, due to transistor 70 being on) will turn on harder, discharging data conductor DBUSₖ (and dummy data conductor DDBUSₖ) to ground; transistors 64p, 65p operate similarly if data conductor DBUSₖ and dummy data conductor DDBUSₖ drift low. As a result, the precharged level of data bus conductors DBUS in data bus 22 of memory 1 is maintained, and is maintained near the trip point of output stage 80, in the preferred embodiment of the invention, even over long precharge and equilibration periods.

Referring back to Figure 4, the next read access operation begins at time t₂ with lines GEQT, GEQC returning low and high, respectively. For clarity of explanation, it is presumed that the next access is also from array block 10ⱼ; the operation of data conductor DBUSₖ will be similar, however, if a different array block 10 were selected. With the end of precharge at time t₂, sense amplifier 13ⱼₖ is again enabled. In this example, the next data state to be presented is a "0", and accordingly node SNTⱼₖ is driven low by sense amplifier 13ⱼₖ at the end of the precharge and equilibration period. Self-biasing circuits 54T, 54C are disabled by lines GEQT, GEQC returning low and high, respectively, and therefore data driver 15ⱼₖ begins driving data conductor DBUSₖ low from the precharged level (and also begins driving dummy data conductor DDBUSₖ high).

Also at this time, upon the return of lines GEQT, GEQC low and high, respectively, output stage 80 is again enabled to receive the data state on data conductor DBUSₖ. Since the construction of output stage 80 and self-biasing circuit 54T is similar, except for transistor scaling, the precharged voltage to which data conductor DBUSₖ is held is quite close to the trip voltage of output stage 80. Accordingly, input/output circuitry 20 can respond very quickly to the discharging (in this case) of data conductor DBUSₖ from its midlevel voltage, in this case immediately after time t₂. This provides savings in the access time of memory 1 from that in prior configurations where data conductors in data buses would, in the worst case, have to be switched from rail-to-rail. Figure 4 illustrates the rail-to-rail discharging of data conductor DBUSₖ' in such a prior arrangement. Assuming that the new access begins at the same time (i.e., time t₂), prior data conductor DBUSₖ' does not reach the trip point of output stage 80 until well after time t₂, due to the R-C load presented thereby to its driver. The access time savings provided by the present invention is illustrated in Figure 4 by Δt, which in modern high speed SRAMs can be on the order of 1.5 to 2.0 nsec, and thus on the order of 10% of the overall access time of memory 1.

During the active period between times t₂ and t₃, dummy data conductor DDBUSₖ is driven by tristate driver 15ⱼₖ to the opposite data state (in this case a "1") from that of data conductor DBUSₖ. Termination 37ₖ adds a load to dummy data conductor DDBUSₖ similar to that of output stage 80, and as such the switching of dummy data conductor DDBUSₖ matches, in a complementary fashion, the switching of data conductor DBUSₖ. As a result, the state of dummy data conductor DDBUSₖ is complementary to that of data conductor DDBUSₖ at all times during the active period, even during the transient switching time. The provision of the matching load by termination 37ₖ thus allows the next precharge operation to begin at any time, as may occur in circuits such as SRAM memory 1, ensuring that charge sharing will precharge data conductor DBUSₖ to the proper midlevel voltage.

The opposite transition of data conductor DBUSₖ is illustrated in Figure 4, beginning with precharge and equilibration at time t₃. In this case, as lines GEQT, GEQC are driven high and low, respectively node SNTⱼₖ is pulled high to place tristate driver 15ⱼₖ in its high impedance state, transistor 70 is turned on to equilibrate data conductor DBUSₖ and dummy data conductor DDBUSₖ which are thus precharged, by way of charge sharing, to a midlevel voltage. Self-biasing circuits 54T, 54C operate as before to maintain this precharged level on data conductor DDBUSₖ. Beginning at time t₄, the next access begins with lines GEQT, GEQC returning low and high, respectively, at which time the new high level data state is presented by node SNCⱼₖ driven low by sense amplifier 13ⱼₖ.

The present invention thus provides the significant advantage of improved access times, by reducing the time required to switch high capacitance internal data buses. The instantaneous dynamic current drawn by memory 1 is also reduced, as the switching voltage of the data conductors in the internal data bus is reduced by approximately one-half. These advantages are achieved by way of charge sharing, thus not requiring generation of a precharge voltage driver and the circuitry necessary to apply the generated precharge voltage; in addition, self-biasing circuits are provided to prevent floating of the data bus to undesired voltages, particularly in long precharge and equilibration periods, as such floating could slow the access time in the next cycle. Furthermore, the precharging of the data bus is facilitated by a tristate data driver which enters the high impedance mode by operation of the sense amplifier, without requiring an additional timing and control signal to be applied thereto.

While the invention has been described herein relative to its preferred embodiment, it is of course contemplated that modifications of, and alternatives to, this embodiment, such modifications and alternatives obtaining the advantages and benefits of this invention, will be apparent to those of ordinary skill in the art having reference to this specification and its drawings.

## Claims

1. An integrated circuit, comprising;
functional circuitry;
a data bus (22) comprising first (DBUSₖ) and second (DDBUSₖ) data conductors, for communicating a differential voltage thereon, said differential voltage being comprised of a first voltage on said first data conductor and a second voltage on said second data conductor;
first and second data drivers (15ⱼₖ), each having an input (SNCⱼₖ,SNTⱼₖ) coupled to said functional circuitry for receiving information therefrom, and having an output (GDCⱼₖ, GDTⱼₖ), for driving said first and second data conductors to a differential voltage corresponding to said information;
means for generating a control signal (GEQT,GEQC) upon the initiation of a memory operation;
circuitry, for establishing and maintaining said first and second data conductors at a voltage intermediate of said first and second voltages, comprising;
a transistor (70) having a conduction path connected between said first and second data conductors, and having a control terminal for receiving said control signal (GEQT,GEQC), for connecting said first and second data conductors together, when at said differential voltage, responsive to said control signal (GEQT, GEQC) ; and
first and second self-biasing circuits (54T,54C) coupled to said first and second data conductors, respectively, each biased by first and second bias voltages, each operable together with said transistor (70) to establish and maintain its associated data conductor at a voltage intermediate of said first and second voltages, each self-biasing circuit comprising:
a pull-up transistor (64p,65p) having a conduction path coupled between its associated data conductor and said first bias voltage, and having a control terminal connected to its associated data conductor, said pull-up transistor (64p,65p) being of a conductivity type such that it is conductive responsive to its associated data conductor being at a voltage near said second bias voltage; and
a pull-down transistor (64n,65n) having a conduction path coupled between its associated data conductor and said second bias voltage, and having a control terminal connected to its associated data conductor, said pull-down transistor (64n,65n) being of a conductivity type such that it is conductive responsive to its associated data conductor being at a voltage near said first bias voltage.

2. The circuit of claim 1, wherein said functional circuitry comprises;
an array of memory cells (10ⱼ);
address terminals (Aₒ,A₁....Aₙ);
means for selecting a memory cell responsive to an address signal received at said address terminals;
and
a sense amplifier (13ⱼₖ), for sensing the data state of said selected memory cell.

3. The circuit of claim 2, wherein a control signal generating means comprises;
an address transition detection circuit (25,29) coupled to said address terminals (Aₒ,A₁,..Aₙ), for detecting logic level transitions thereat, and for presenting a control signal (GEQT,GEQC) responsive to one of said logic level transitions.

4. The circuit of claim 1, wherein said data bus (22) comprises a plurality of pairs of first and second data conductors;
wherein said circuit comprises a plurality of said first and second data drivers (15), each having an input coupled to said functional circuitry for receiving information therefrom, and each having first and second outputs (GDCⱼₖ,GDTⱼₖ) for driving an associated pair of said first and second data conductors with a differential signal corresponding to said information.

5. The circuit of claim 1, further comprising:
a parallel data driver (l5ⱼ/ₖ), having an input coupled to said functional circuitry for receiving information therefrom, having first and second outputs (SNCⱼ/ₖ,SNTⱼ/ₖ) for driving said first and second data conductors with a differential signal corresponding to said information;
wherein said data driver (15ⱼₖ) and said parallel data driver (15ⱼ/ₖ) are controlled by said functional circuitry so as to not simultaneously drive said first and second data conductors with a differential signal.

6. The circuit of claim 1, wherein each of said self-biasing circuits further comprise;
a first series transistor (66,67) having a conduction path coupled in series with the conduction path of said pull-up transistors (64p,65p) between the data conductor associated with the self-biasing circuit (54T,54C) and said first bias voltage; and
a second series transistor (68,69) having a conduction path coupled in series with the conduction path of said pull-down transistor (64n,65n) between the data conductor associated with the self-biasing circuit (54T,54C) and said second bias voltage;
wherein said first and second series transistors (66,67) each have a control terminal coupled to said control signal generating means in such a manner that said first and second series transistors are conductive responsive to said control signal (GEQT,GEQC) and non-conductive in the absence of said control signal.

7. The circuit of claim 1, further comprising an output stage (20) coupled to said first data conductor, comprising:
an output pull-up transistor (72p) having a conduction path coupled between an output node and said first bias voltage, and having a control terminal coupled to said first data conductor in such a manner that said output pull-up transistor (72p) is conductive responsive to said first data conductor being at a voltage near said second bias voltage; and
an output pull-down transistor(72n) having a conduction path coupled between said output node and said second bias voltage, and having a control terminal coupled to said first data conductor in such a manner that said output pull-down transistor (72n) is conductive responsive to said first data conductor being at a voltage near said first bias voltage.

8. The circuit of claim 7, wherein said output stage (20) further comprises:
a first series transistor (74) having a conduction path coupled in series with the conduction path of said output pull-up transistor (72p) between said output node and said first bias voltage; and
a second series transistor (76) having a conduction path coupled in series with the conduction path of said output pull-down transistor (72n) between said output node and said second bias voltage;
wherein said first and second series transistors (74,76) each have a control terminal coupled to said control signal generating means in such a manner that said first and second series transistors are non-conductive in response to said control signal (GEQT,GEQC) and conductive in the absence of said control signal.

9. The circuit of claim 8, wherein said first self-biasing circuit (54T) further comprises:
a first series transistor (66) having a conduction path coupled in series with the conduction path of said pull-up transistor (64p) between said first data conductor and said first bias voltage; and
a second series transistor (68) having a conduction path coupled in series with the conduction path of said pull-down transistor (64n) between said first data conductor and said second bias voltage;
wherein said first and second series transistors (66,68) of said first biasing circuit each has a control terminal coupled to said control signal generating means in such a manner that said first and second series transistors of said first biasing circuit are conductive responsive to said control signal (GEQT,GEQC) and non-conductive in the absence of said control signal.

10. The circuit of claim 7, further comprising:
a termination (37ₖ) coupled to said second data conductor, said termination presenting a load to said second data conductor which is substantially similar to the load presented by said output stage to said first data conductor.

11. A method of operating an integrated circuit, said integrated circuit including functional circuitry coupled to a data bus (22) having first and second differential data conductors therein upon which said functional circuitry presents a differential voltage resulting from an operation by said functional circuitry, one of said pair of data conductors connected to an output stage (20), comprising:
driving said differential data conductors with a differential voltage corresponding to the result of the operation of the functional circuitry, said first data conductor being driven to a first voltage and said second conductor being driven to a second voltage;
after said driving step, isolating said data conductors from said functional circuitry;
after said isolating step, establishing and maintaining said first and second data conductors at a voltage intermediate of said first and second voltages by:
connecting said pair of data conductors, at said differential voltage, to one another;
responsive to said first data conductor having a voltage near a first bias voltage, turning on a transistor connected between said first data conductor and a second bias voltage; and
responsive to said first data conductor having a voltage near said second bias voltage, turning on a transistor connected between said first data conductor and said first bias voltage.

12. The method of claim 11, wherein said first one of said data conductors is coupled to said output stage (20); and further comprising:
after said driving step, turning off said output stage (20) so that it no longer responds to said first data conductor; and
after said isolating step, turning on said output stage (20) responsive to another operation by said functional circuitry.

13. The method of claim 11, further comprising:
after said isolating step, responsive to another operation by said functional circuitry, disconnecting said pair of data conductors from one another so that another differential signal may be presented thereon.

14. The method of claim 13, wherein said integrated circuit comprises a memory (10) having a plurality of memory cells, each for storing a data state;
and further comprising:
selecting one (10ⱼₖ) of said plurality of memory cells in said array;
sensing the stored data state in said selected memory cell; and
driving said pair of data conductors with a differential signal corresponding to the sensed stored data state.

15. The method of claim 14, wherein said plurality of memory cells are arranged in a plurality of array blocks (10ⱼ);
wherein each of said array blocks is associated with one of a plurality of data drivers coupled to said pair of data conductors;
and further comprising:
selecting one of said array blocks (10ⱼ) responsive to an address value (Aₒ,A₁...Aₙ); and
deselecting the data drivers coupled to said pair of data conductors which are associated with unselected array blocks.

16. The method of claim 13, wherein said functional circuitry comprises a memory comprising:
a plurality of memory cells; and
means for selecting one of said plurality of memory cells responsive to an address signal (Aₒ,A₁...Aₙ) received at a plurality of address terminals;
said method further comprising:
detecting the initiation of an access to one (10ⱼₖ) of said plurality of memory cells;
wherein said connecting step is performed in response to said detecting step.

17. The method of claim 11, further comprising:
after said isolating step, responsive to said second data conductor having a voltage near said first bias voltage, turning on a transistor connected between said second data conductor and said second bias voltage; and
responsive to said second data conductor having a voltage near said second bias voltage, turning on a transistor connected between said second data conductor and said first bias voltage.

## Patentansprüche

1. Integrierter Schaltkreis mit:
einem funktionellen Schaltkreis;
einem Datenbus (22) mit ersten (DBUSₖ) und zweiten (DDBUSₖ) Datenleitungen zum Kommunizieren bzw. Übertragen einer differentiellen Spannung darauf, wobei die differentielle Spannung sich aus einer ersten Spannung auf dem ersten Datenleiter und einer zweiten Spannung auf dem zweiten Datenleiter zusammensetzt;
ersten und zweiten Datentreibern bzw. Ansteuervorrichtungen (15ⱼₖ), wobei jede einen Eingang (SNCⱼₖ, SNTⱼₖ) aufweist, welcher mit dem Funktionsschaltkreis gekoppelt ist, um Informationen davon zu erhalten, und einen Ausgang (GDCⱼₖ, GDTⱼₖ) aufweist, zum Ansteuern bzw. Treiben der ersten und zweiten Datenleiter zu einer differentiellen Spannung, welche der Information entspricht;
eine Vorrichtung zum Erzeugen eines Regel- bzw. Steuersignals (GEQT, GEQC) bei dem Beginn einer Speicheroperation bzw. eines Speichervorganges;
einem Schaltkreis zum Festsetzen und Aufrechterhalten der ersten und zweiten Datenleiter bei einer Spannung zwischen der ersten und der zweiten Spannung, mit:
einem Transistor (70) mit einer Leiterbahn bzw. einem Leitungsweg, welcher zwischen den ersten und zweiten Datenleitern geschaltet bzw. verbunden ist, und einen Regel- bzw. Steueranschluß zum Empfangen bzw. Aufnehmen des Regel- bzw. Steuersignals (GEQT, GEQC) umfaßt, zum Verbinden der ersten und zweiten Datenleiter miteinander, wenn diese bei der differentiellen Spannung sind, in Reaktion auf das Regel- bzw. Steuersignal (GEQT, GEQC); und
erste und zweite selbstvorspannende (self-biasing) Schaltkreise (54T, 54C), welche mit den ersten und zweiten Datenleitern jeweils gekoppelt sind, wobei jeder mit ersten und zweiten Vorspannungsspannungen (bias voltage) vorgespannt (bias) wird, wobei jeder zusammen mit dem Transistor (70) betrieben werden kann, um dessen zugeordneten bzw. zugehörigen Datenleiter bei einer Spannung festzusetzen und beizubehalten, welche zwischen den ersten und zweiten Spannungen ist, wobei jeder selbstvorspannende Schaltkreis umfaßt:
einen Pull-up-Transistor (64p, 65p) mit einer Leiterbahn, welche zwischen dessen zugehörigem Datenleiter und dessen erster Vorspannungsspannung gekoppelt ist, und einen Regel- bzw. Steueranschluß aufweist, welcher mit dessen zugehörigem Datenleiter verbunden ist, wobei der Pull-up-Transistor (64p, 65p) von einem Leitfähigkeitstyp ist, so daß dieser leitfähig ist in Reaktion darauf, wenn dessen zugehöriger bzw. zugeordneter Datenleiter bei einer Spannung nahe der zweiten Vorspannungsspannung ist; und
einen Pull-down-Transistor (64n, 65n) mit einer Leiterbahn bzw. einem Leitungsweg, welcher zwischen dessen zugehörigem Datenleiter und der zweiten Vorspannungsspannung gekoppelt ist, und einen Regel- bzw. Steueranschluß aufweist, welcher mit dessen zugehörigem Datenleiter verbunden ist, wobei der Pull-down-Transistor (64n, 65n) von einem Leitfähigkeitstyp ist, so daß dieser leitfähig ist in Reaktion darauf, wenn dessen zugehöriger Datenleiter bei einer Spannung nahe der ersten Vorspannungsspannung ist.

2. Schaltkreis nach Anspruch 1, wobei der Funktionsschaltkreis umfaßt:
ein Feld bzw. Array von Speicherzellen (10ⱼ);
Adreßanschlüsse (A₀, A₁, ... Aₙ);
eine Vorrichtung zum Auswählen einer Speicherzelle in Reaktion auf bzw. in Abhängigkeit von einem Adressensignal, welches bei den Adreßanschlüssen empfangen bzw. aufgenommen wurde;
und
einem Leseverstärker (13ⱼₖ) zum Lesen des Datenzustands der ausgewählten Speicherzelle.

3. Schaltkreis nach Anspruch 2, wobei eine Regel- bzw. Steuersignalerzeugungsvorrichtung umfaßt:
einen Adressenübergangs-Erkennungs- bzw. -Detektierschaltkreis (25, 29), welcher mit den Adreßanschlüssen (A₀, A₁, ... Aₙ) gekoppelt bzw. verbunden ist zum Erkennen bzw. Detektieren der logischen Pegel- bzw. Niveau-Übergänge daran und zum Darstellen eines Regel- bzw. Steuersignals (GEQT, GEQC) in Reaktion auf bzw. in Abhängigkeit von einem der logischen Pegelübergänge.

4. Schaltkreis nach Anspruch 1, wobei der Datenbus (22) eine Vielzahl von Paaren von ersten und zweiten Datenleitern aufweist;
wobei der Schaltkreis eine Vielzahl von ersten und zweiten Datentreibem bzw. Ansteuervorrichtungen (15) aufweist, wobei jeder einen Eingang hat, welcher mit dem Funktionsschaltkreis gekoppelt ist zum Empfangen von Informationen davon und jeder erste und zweite Ausgänge (GDCⱼₖ, GDTⱼₖ) aufweist zum Ansteuem bzw. Treiben eines zugeordneten bzw. entsprechenden Paares der ersten und zweiten Datenleiter mit einem differentiellen Signal entsprechend der Information.

5. Schaltkreis nach Anspruch 1, weiter aufweisend:
einen parallelen Datentreiber (15ⱼ/ₖ), welcher einen Eingang aufweist, welcher mit dem Funktionsschaltkreis gekoppelt ist zum Empfangen bzw. Aufnehmen von Informationen davon, und welcher erste und zweite Ausgänge (SNCⱼ/ₖ, SNTⱼ/ₖ) hat zum Ansteuern bzw. Treiben der ersten und zweiten Datenleiter mit einem differentiellen Signal, welches der Information entspricht;
wobei der Datentreiber (15ⱼₖ) und der parallele Datentreiber (15ⱼ/ₖ) geregelt bzw. gesteuert werden durch den Funktionsschaltkreis, so daß nicht gleichzeitig die ersten und zweiten Datenleiter mit einem differentiellen Signal getrieben bzw. angesteuert werden.

6. Schaltkreis nach Anspruch 1, wobei jeder der selbstvorspannenden Schaltkreise weiter umfaßt:
einen ersten seriellen Transistor (66, 67) mit einem Leitungsweg bzw. Leitungspfad, welcher seriell mit dem Leitungsweg des Pull-up-Transistors (64p, 65p) gekoppelt ist zwischen dem Datenleiter, welcher dem selbstvorspannenden Schaltkreis (54T, 54C) zugeordnet ist bzw. entspricht, und der ersten Vorspannungsspannung; und
einem zweiten seriellen Transistor (68, 69) mit einem Leitungsweg, welcher seriell mit dem Leitungsweg des Pull-down-Transistors (64n, 65n) gekoppelt ist zwischen dem Datenleiter, welcher dem selbstvorspannenden Schaltkreis (54T, 54C) und der zweiten Vorspannungsspannung entspricht,
wobei die ersten und zweiten seriellen Transistoren (66, 67) jeweils einen Regelbzw. Steueranschluß aufweisen, welcher mit der Regel- bzw. Steuersignalerzeugungsvorrichtung in einer solchen Art gekoppelt sind, daß die ersten und zweiten seriellen Transistoren leitfähig sind in Reaktion auf bzw. in Abhängigkeit von dem Regel- bzw. Steuersignal (GEQT, GEQC) und nichtleitfähig sind bei dem Fehlen des Regel- bzw. Steuersignals.

7. Schaltkreis nach Anspruch 1, weiter aufweisend eine Ausgangsstufe (20), welche mit dem ersten Datenleiter gekoppelt ist, mit:
einem Ausgangs- bzw. Ausgabe-Pull-up-Transistor (72p) mit einem Leitungsweg, welcher zwischen dem Ausgangsknoten und der ersten Vorspannungsspannung gekoppelt ist, und einen Regel- bzw. Steueranschluß aufweist, welcher mit dem ersten Datenleiter in einer solchen Art gekoppelt ist, daß der Ausgangs- bzw. Ausgabe-Pull-up-Transistor (72p) leitfähig ist in Reaktion auf bzw. in Abhängigkeit von dem ersten Datenleiter, welcher bei einer Spannung nahe der zweiten Vorspannungsspannung ist; und
einem Ausgangs- bzw. Ausgabe-Pull-down-Transistor (72n) mit einem Leitungsweg, welcher zwischen dem Ausgangsknoten und der zweiten Vorspannungsspannung gekoppelt ist, und einen Regel- bzw. Steueranschluß aufweist, welcher mit dem ersten Datenleiter in einer solchen Art gekoppelt ist, daß der Ausgangs- bzw. Ausgabe-Pull-down-Transistor (72n) leitfähig ist in Reaktion auf bzw. in Abhängigkeit von dem ersten Datenleiter, welcher bei einer Spannung nahe der ersten Vorspannungsspannung ist.

8. Schaltkreis nach Anspruch 7, wobei die Ausgangsstufe 20 weiter aufweist:
einen ersten seriellen Transistor (74) mit einem Leitungsweg, welcher seriell mit dem Leitungsweg des Ausgangs-Pull-up-Transistors (72p) gekoppelt ist zwischen dem Ausgangsknoten und der ersten Vorspannungsspannung; und
einen zweiten seriellen Transistor (76) mit einem Leitungsweg, welcher in Serie gekoppelt ist mit dem Leitungsweg des Ausgangs-Pull-down-Transistors (72n) zwischen dem Ausgangsknoten und der zweiten Vorspannungsspannung;
wobei die ersten und zweiten seriellen Transistoren (74, 76) jeweils einen Regel-bzw. Steueranschluß aufweisen, welcher mit der Regel- bzw. Steuersignal-Erzeugungsvorrichtung auf eine solche Art gekoppelt ist, daß die ersten und zweiten seriellen Transistoren nicht leitfähig sind in Reaktion auf bzw. in Abhängigkeit von dem Regel-bzw. Steuersignal (GEQT, GEQC) und leitfähig sind bei dem Fehlen des Regel- bzw. Steuersignals.

9. Schaltkreis nach Anspruch 8, wobei der erste selbstvorspannende Schaltkreis (54T) weiter umfaßt:
einen ersten seriellen Transistor (66) mit einem Leitungsweg, welcher seriell mit dem Leitungsweg des Pull-up-Transistors (64p) gekoppelt ist zwischen dem ersten Datenleiter und der ersten Vorspannungsspannung; und
einen zweiten seriellen Transistor (68) mit einem Leitungsweg, welcher in Serie gekoppelt ist mit dem Leitungsweg des Pull-down-Transistors (64n) zwischen dem ersten Datenleiter und der zweiten Vorspannungsspannung;
wobei die ersten und zweiten seriellen Transistoren (66, 68) des ersten Vorspannungsschaltkreises jeweils einen Regel- bzw. Steueranschluß aufweisen, welche mit der Regel- bzw. Steuersignal-Erzeugungsvorrichtung auf eine solche Art gekoppelt sind, daß die ersten und zweiten seriellen Transistoren des ersten Vorspannungsschaltkreises leitfähig sind in Reaktion auf bzw. in Abhängigkeit von dem Regel- bzw. Steuersignal (GEQT, GEQC) und nicht leitfähig sind bei dem Fehlen des Regel- bzw. Steuersignals.

10. Schaltkreis nach Anspruch 7, weiter aufweisend:
einen Abschluß (37ₖ), welcher mit dem zweiten Datenleiter gekoppelt ist, wobei der Abschluß eine Last bei dem zweiten Datenleiter darstellt, welcher im wesentlichen ähnlich zu der Last ist, welche durch die Ausgangsstufe bei dem ersten Datenleiter angelegt bzw. dargestellt wird.

11. Verfahren zum Betreiben eines integrierten Schaltkreises, wobei der integrierte Schaltkreis einen Funktionsschaltkreis umfaßt, welcher mit einem Datenbus (22) gekoppelt ist, welcher erste und zweite differentielle Datenleiter darin aufweist, auf welchem der Funktionsschaltkreis eine differentielle Spannung darstellt, welche von einem Arbeitsvorgang durch den Funktionsschaltkreis resultieren bzw. stammen, wobei eines der Paare der Datenleiter mit einer Ausgangsstufe (20) verbunden ist, mit:
Ansteuern der differentiellen Datenleiter mit einer differentiellen Spannung entsprechend dem Ergebnis des Arbeitsvorgangs des Funktionsschaltkreises, wobei der erste Datenleiter zu einer ersten Spannung getrieben bzw. ausgesteuert wird und der zweite Leiter zu einer zweiten Spannung getrieben bzw. ausgesteuert wird;
nach dem Aussteuer- bzw. Treiberschritt werden die Datenleiter von dem Funktionsschaltkreis getrennt;
nach dem Trennungsschritt werden die ersten und zweiten Datenleiter mit einer Spannung zwischen der ersten und der zweiten Spannung eingestellt bzw. festgesetzt und beibehalten durch:
Verbinden des Paars der Datenleitungen bzw. Datenleiter bei der differentiellen Spannung miteinander;
in Reaktion darauf, daß der erste Datenleiter eine Spannung nahe einer ersten Vorspannungsspannung aufweist, wird ein Transistor angeschaltet, welcher zwischen dem ersten Datenleiter und einer zweiten Vorspannungsspannung verbunden ist; und
in Reaktion darauf, daß der erste Datenleiter eine Spannung nahe der zweiten Vorspannungsspannung aufweist, wird ein Transistor angeschaltet, welcher zwischen dem ersten Datenleiter und der ersten Vorspannungsspannung verbunden ist.

12. Verfahren nach Anspruch 11, wobei der erste der Datenleiter mit der Ausgangsstufe (20) gekoppelt ist; und weiter aufweist:
nach dem Ansteuer- bzw. Treibschritt wird die Ausgangsstufe (20) ausgeschaltet, so daß diese nicht länger auf den ersten Datenleiter anspricht; und
nach dem Trennungsschritt, Anschalten der Ausgangsstufe (20) in Rektion auf bzw. in Abhängigkeit von einem anderen Vorgang durch den funktionellen bzw. Funktionsschaltkreis.

13. Verfahren nach Anspruch 11, weiter aufweisend:
nach dem Trennungsschritt in Reaktion auf bzw. in Abhängigkeit von einem anderen Vorgang durch den Funktionsschaltkreis, Trennen des Paares der Datenleitungen bzw. -leiter voneinander, so daß ein anderes differentielles Signal darauf dargestellt werden kann.

14. Verfahren nach Anspruch 13, wobei der integrierte Schaltkreis einen Speicher (10) aufweist mit einer Vielzahl von Speicherzellen, jede zum Speichern eines Datenzustandes;
und weiter aufweist:
Auswählen einer (10ⱼₖ) aus der Vielzahl von Speicherzellen in dem Feld;
Lesen des gespeicherten Datenzustandes in der ausgewählten Speicherzelle; und
Ansteuern bzw. Treiben des Paares der Datenleiter mit einem differentiellen Signal entsprechend dem gelesenen gespeicherten Datenzustand.

15. Verfahren nach Anspruch 14, wobei die Vielzahl der Speicherzellen in einer Vielzahl von Feld- bzw. Arrayblöcken (10ⱼ) angeordnet sind;
wobei jeder der Feldblöcke einem aus einer Vielzahl von Datentreibern zugeordnet ist bzw. entspricht, welcher mit dem Paar der Datenleiter gekoppelt ist;
und weiter aufweist:
Auswählen eines der Feldblöcke (10ⱼ) in Reaktion auf bzw. in Abhängigkeit von einem Adressenwert (A₀, A₁, ... Aₙ); und
Nichtauswählen der Datentreiber, welche mit dem Paar der Datenleiter gekoppelt sind, welche nicht ausgewählten Feldblöcken entsprechen bzw. diesen zugeordnet sind.

16. Verfahren nach Anspruch 13, wobei der Funktionsschaltkreis einen Speicher aufweist, mit:
einer Vielzahl von Speicherzellen; und
einer Vorrichtung zum Auswählen einer aus der Vielzahl der Speicherzellen in Abhängigkeit von bzw. in Reaktion auf ein Adressensignal (A₀, A₁, ... Aₙ), welches bei einer Vielzahl der Adreßanschlüsse erhalten bzw. empfangen wurde;
wobei das Verfahren weiter aufweist:
Erkennen bzw. Detektieren des Beginns eines Zugriffs auf eine (10ⱼₖ) aus der Vielzahl der Speicherzellen;
wobei der Verbindungsschritt in Reaktion auf bzw. in Abhängigkeit von dem Erkennungs- bzw. Detektierschritt durchgeführt wird.

17. Verfahren nach Anspruch 11, weiter aufweisend:
nach dem Trennungsschritt in Reaktion auf den zweiten Datenleiter, welcher eine Spannung nahe bei der ersten Vorspannungsspannung aufweist, Anschalten eines Transistors, welcher zwischen dem zweiten Datenleiter und der zweiten Vorspannungsspannung verbunden ist; und
in Reaktion auf den zweiten Datenleiter mit einer Spannung nahe bei der zweiten Vorspannungsspannung, Anschalten eines Transistors, welcher zwischen dem zweiten Datenleiter und der ersten Vorspannungsspannung verbunden ist.

## Revendications

1. Circuit intégré comprenant :
un circuit fonctionnel ;
un bus de données (22) comprenant des premier (DBUSₖ) et second (DDBUSₖ) conducteurs de données, pour transmettre une tension différentielle, ladite tension différentielle étant constituée d'une première tension sur le premier conducteur de données et d'une seconde tension sur le second conducteur de données ;
des premier et second circuits pilotes de données (15ⱼₖ), ayant chacun une entrée (SNCⱼₖ, SNTⱼₖ) couplée au circuit fonctionnel pour en recevoir des informations, et ayant une sortie (GDCⱼₖ, GDTⱼₖ) pour piloter les premier et second conducteurs de données à une tension différentielle correspondant auxdites informations ;
un moyen pour produire un signal de commande (GEQT, GEQC) au début d'une opération de mémoire ;
un circuit pour établir et maintenir les premier et second conducteurs de données à une tension intermédiaire entre les première et seconde tensions, comprenant :
un transistor (70) ayant un trajet de conduction connecté entre les premier et second conducteurs de données et ayant une borne de commande pour recevoir le signal de commande (GEQT, GEQC) pour connecter les premier et second conducteurs de données l'un à l'autre, quand ils sont à la tension différentielle, en réponse au signal de commande (GEQT, GEQC) ; et
des premier et second circuits d'autopolarisation (54T, 54C) couplés au premier et second conducteurs de données, respectivement, chacun étant polarisé par des première et seconde tensions de polarisation, chacun pouvant fonctionner avec le transistor (70) pour établir et maintenir son conducteur de données associé à une tension intermédiaire entre les première et seconde tensions, chaque circuit d'autopolarisation comprenant :
un transistor de mise à niveau haut (64p, 65p) ayant un trajet de conduction couplé entre son conducteur de données associé et la première tension de polarisation et ayant une borne de commande connectée à son conducteur de données associé, ledit transistor de mise à niveau haut (64p, 65p) étant d'un type de conduction tel qu'il est conducteur en réponse au fait que son conducteur de données associé est à une tension proche de la seconde tension de polarisation ; et
un transistor de mise à niveau bas (64n, 65n) ayant un trajet de conduction couplé entre son conducteur de données associé et la seconde tension de polarisation et ayant une borne de commande connectée à son conducteur de données associé, le transistor de mise à niveau bas (64n, 65n) étant d'un type de conduction tel qu'il est conducteur en réponse au fait que son conducteur de données associé est à une tension proche de la première tension de polarisation.

2. Circuit selon la revendication 1, dans lequel le circuit fonctionnel comprend :
une matrice de cellules mémoire (10ⱼ) ;
des bornes d'adresse (A₀, A₁...Aₙ) ;
des moyens pour sélectionner une cellule mémoire en réponse à un signal d'adresse reçu sur les bornes d'adresse ; et
un amplificateur de lecture (13ⱼₖ) pour détecter l'état des données de la cellule mémoire sélectionnée.

3. Circuit selon la revendication 2, dans lequel un moyen de génération de signal de commande comprend un circuit de détection de transition d'adresse (25, 29) couplé aux bornes d'adresse (A₀, A₁...Aₙ) pour détecter des transitions de niveau logique sur celles-ci et pour présenter un signal de commande (GEQT, GEQC) en réponse à l'une des transitions de niveau logique.

4. Circuit selon la revendication 1, dans lequel le bus de données (22) comprend plusieurs paires de premier et second conducteurs de données, ledit circuit comprenant plusieurs premiers et seconds circuits pilotes de données (15) ayant chacun une entrée couplée au circuit fonctionnel pour en recevoir des informations et ayant chacun des première et seconde sorties (GDCⱼₖ, GDTⱼₖ) pour piloter une paire associée de premier et second conducteurs de données par un signal différentiel correspondant auxdites informations.

5. Circuit selon la revendication 1, comprenant en outre :
un circuit pilote de données parallèle (15_{j/k}) ayant une entrée couplée au circuit fonctionnel pour en recevoir des informations, ayant des première et seconde sorties (SNC_{j/k}, SNT_{j/k}) pour piloter les premier et second conducteurs de données par un signal différentiel correspondant auxdites informations ;
dans lequel le circuit pilote de données (15ⱼₖ) et le circuit pilote de données parallèle (15_{j/k}) sont commandés par ledit circuit fonctionnel de façon à ne pas piloter simultanément les premier et second conducteurs de données par un signal différentiel.

6. Circuit selon la revendication 1, dans lequel chacun des circuits d'autopolarisation comprend en outre :
un premier transistor série (66, 67) ayant un trajet de conduction couplé en série avec le trajet de conduction des transistors de mise à niveau haut (64p, 65p) entre le conducteur de données associé au circuit d'autopolarisation (54T, 54C) et la première tension de polarisation ; et
un second transistor série (68, 69) ayant un trajet de conduction couplé en série avec le trajet de conduction du transistor de mise à niveau bas (64n, 65n) entre le conducteur de données associé au circuit d'autopolarisation (54T, 54C) et la seconde tension de polarisation ;
dans lequel les premier et second transistors série (66, 67) ont chacun une borne de commande couplée au moyen de génération de signal de commande de sorte que les premier et second transistors série sont conducteurs en réponse au signal de commande (GEQT, GEQC) et non conducteurs en l'absence du signal de commande.

7. Circuit selon la revendication 1, comprenant en outre un étage de sortie (20) couplé au premier conducteur de données, comprenant :
un transistor de mise à niveau haut de sortie (72p) ayant un trajet de conduction couplé entre un noeud de sortie et la première tension de polarisation, et ayant une borne de commande couplée au premier conducteur de données de sorte que le transistor de mise à niveau haut de sortie (72p) est conducteur en réponse au fait que le premier conducteur de données est à une tension proche de la seconde tension de polarisation ; et
un transistor de mise à niveau bas de sortie (72n) ayant un trajet de conduction couplé entre le noeud de sortie et la seconde tension de polarisation, et ayant une borne de commande couplée au premier conducteur de données de sorte que le transistor de mise à niveau bas de sortie (72n) est conducteur en réponse au fait que le premier conducteur de données est à une tension proche de la première tension de polarisation.

8. Circuit selon la revendication 7, dans lequel l'étage de sortie (20) comprend en outre :
un premier transistor série (74) ayant un trajet de conduction couplé en série dans le trajet de conduction du transistor de mise à niveau haut de sortie (72p) entre le noeud de sortie et la première tension de polarisation ; et
un second transistor série (76) ayant un trajet de conduction couplé en série dans le trajet de conduction du transistor de mise à niveau bas de sortie (72n) entre le noeud de sortie et la seconde tension de polarisation ;
dans lequel les premier et second transistors série (74, 76) ont chacun une borne de commande couplée au moyen de génération de signal de commande de sorte que les premier et second transistors série sont non conducteurs en réponse au signal de commande (GEQT, GEQC) et conducteurs en l'absence de signal de commande.

9. Circuit selon la revendication 8, dans lequel le premier circuit d'autopolarisation (54T) comprend en outre :
un premier transistor série (66) ayant un trajet de conduction couplé en série dans le trajet de conduction du transistor de mise à niveau haut (64p) entre le premier conducteur de données et la première tension de polarisation ; et
un second transistor série (68) ayant un trajet de conduction couplé en série dans le trajet de conduction du transistor de mise à niveau bas (64n) entre le premier conducteur de données et la seconde tension de polarisation ;
dans lequel les premier et second transistors série (66, 68) du premier circuit de polarisation ont chacun une borne de commande couplée au moyen de génération de signal de commande de sorte que les premier et second transistors série du premier circuit de polarisation sont conducteurs en réponse au signal de commande (GEQT, GEQC) et non conducteurs en l'absence du signal de commande.

10. Circuit selon la revendication 7, comprenant en outre une terminaison (37ₖ) couplée au second conducteur de données, ladite terminaison présentant une charge au second conducteur de données qui est sensiblement similaire à la charge présentée par l'étage de sortie au premier conducteur de données.

11. Procédé d'actionnement d'un circuit intégré, ce circuit intégré comprenant un circuit fonctionnel couplé à un bus de données (22) ayant des premier et second conducteurs de données différentiels selon lesquels le circuit fonctionnel présente une tension différentielle résultant d'une action du circuit fonctionnel, l'un des deux conducteurs de données étant connecté à l'étage de sortie (20), comprenant les étapes suivantes :
piloter les conducteurs de données différentiels par une tension différentielle qui correspond au résultat de l'opération du circuit fonctionnel, le premier conducteur de données étant piloté à une première tension et le second conducteur de données étant piloté à une seconde tension ;
après l'étape de pilotage, isoler les conducteurs de données du circuit fonctionnel ;
après l'étape d'isolement, établir et maintenir les premier et second conducteurs de données à une tension intermédiaire entre les première et seconde tensions en :
connectant l'un à l'autre la paire de conducteurs de données à la tension différentielle ;
en réponse au fait que le premier conducteur de données a une tension proche de la première tension de polarisation, rendre passant un transistor connecté entre le premier conducteur de données et une seconde tension de polarisation ; et
en réponse au fait que le premier conducteur de données a une tension proche de la seconde tension de polarisation, rendre passant un transistor connecté entre le premier conducteur de données et la première tension de polarisation.

12. Procédé selon la revendication 11, dans lequel le premier des conducteurs de données est couplé à l'étage de sortie (20) et comprenant en outre les étapes suivantes :
après l'étape de pilotage, couper l'étage de sortie (20) de sorte qu'il ne réponde plus au premier conducteur de données ; et
après l'étape d'isolement, rendre passant l'étage de sortie (20) en réponse à une autre opération du circuit fonctionnel.

13. Procédé selon la revendication 11, comprenant en outre après l'étape d'isolement, en réponse à une autre opération du circuit fonctionnel, une déconnexion des deux conducteurs de données l'un de l'autre de sorte que le signal différentiel peut être présenté sur ces deux conducteurs.

14. Procédé selon la revendication 13, dans lequel le circuit intégré comprend une mémoire (10) comportant une pluralité de cellules mémoire chacune pour mémoriser un état de données, et comprenant en outre les étapes suivantes :
sélectionner l'une (10ⱼₖ) de la pluralité de cellules mémoire du réseau ;
détecter l'état mémorisé des données dans la cellule mémoire sélectionnée ; et
piloter la paire de conducteurs de données par un signal différentiel correspondant à l'état de données mémorisé détecté.

15. Procédé selon la revendication 14, dans lequel la pluralité de cellules mémoire est disposée en une pluralité de blocs matriciels (10ⱼ) ; dans lequel chacun des blocs matriciels est associé à l'un d'une pluralité de circuits pilotes de données couplés à la paire de conducteurs de données ; et comprenant en outre les étapes suivantes :
sélectionner l'un des blocs matriciels (10ⱼ) en réponse à une valeur d'adresse (A₀, A₁...Aₙ) ; et
désélectionner les circuits pilotes de données couplés à la paire de conducteurs de données qui sont associés aux blocs matriciels non sélectionnés.

16. Procédé selon la revendication 13, dans lequel le circuit fonctionnel comprend une mémoire comprenant une pluralité de cellules mémoire et des moyens pour sélectionner l'une de la pluralité de cellules mémoire en réponse à un signal d'adresse (A₀, A₁...Aₙ) reçu sur une pluralité de bornes d'adresse, ce procédé comprenant en outre les étapes suivantes :
détecter le début d'un accès à l'une (10ⱼₖ) de la pluralité de cellules mémoire ;
dans lequel l'étape de connexion est réalisée en réponse à l'étape de détection.

17. Procédé selon la revendication 11, comprenant en outre les étapes suivantes :
après l'étape d'isolement, en réponse au fait que le second conducteur de données a une tension proche de la première tension de polarisation, rendre passant un transistor connecté entre le second conducteur de données et la seconde tension de polarisation ; et
en réponse au fait que le second conducteur de données a une tension proche de la seconde tension de polarisation, rendre passant un transistor connecté entre le second conducteur de données et la première tension de polarisation.
